# EUROPEAN PATENT SPECIFICATION

(11) **EP 2 908 357 B1**
(45) Date of publication and mention of the grant of the patent: **29.08.2018**
(21) Application number: 13844680.2
(22) Date of filing: 10.10.2013
(51) Int. Cl.: H01L 41/08, H01L 41/193, H01L 41/45, H04R 17/00, H01L 41/113

(54) **PIEZOELECTRIC ELEMENT**
PIEZOELEKTRISCHES ELEMENT
ÉLÉMENT PIÉZOÉLECTRIQUE

(30) Priority: 12.10.2012 JP 2012226683; 08.03.2013 JP 2013046414
(43) Date of publication of application: 19.08.2015
(73) Proprietor: Teijin Limited, Osaka-shi, Osaka 541-0054 (JP); Kansai University, Suita-shi, Osaka 564-0073 (JP)
(72) Inventor: TAJITSU, Yoshiro, Suita-shi, Osaka 564-0073 (JP); ONO, Yuhei, Iwakuni-shi, Yamaguchi 740-0014 (JP); UCHIYAMA, Akihiko, Tokyo 100-0013 (JP); YAMAMOTO, Tomoyoshi, Tokyo 100-0013 (JP)
(74) Representative: Carpmaels & Ransford LLP
(86) International application number: PCT/JP2013/078245
(87) International publication number: WO 2014/058077

(56) References cited:
- DE-A1-102010 019 666
- JP-A- S5 437 299
- JP-A- S6 135 581
- JP-A- S60 139 845
- JP-A- 2000 144 545
- JP-A- 2002 203 996
- JP-A- 2005 060 922
- JP-A- 2007 212 436
- JP-A- 2007 518 886
- US-A1- 2011 260 584

## Description

### TECHNICAL FIELD

The present invention relates to a piezoelectric element for use in touch-type input devices and pointing devices. More specifically, it relates to a piezoelectric element capable of generating a sufficient electric output as a touch sensor simply by rubbing the surface or a piezoelectric element which functions as an actuator which changes its shape according to an electric signal applied thereto.

### BACKGROUND ART

The number of so-called input devices employing touch panel system, that is, touch-type input devices is now significantly increasing. Along with the development of thin display technology, the touch panel system as an input interface is increasingly employed in not only bank ATM's and ticket vending machines at stations but also mobile phones, portable game machines and mobile music players.

In recent mobile phones and smart phones, system capable of direct input into the screen by mounting a touch-type input device on a display making use of liquid crystals or organic electroluminescence is often employed. In order to further improve the convenience of portable devices such as smart phones which are being upgraded, it is preferred that not only an input device should be mounted on the screen but also a plurality of touch-type input means should be made available.

For instance, in the case of a smart phone, to input into the display screen with fingers, the smart phone must be held by one hand and the fingers of the other hand must be used for input. Therefore, the smart phone must be operated with both hands. Meanwhile, if a touch sensor is incorporated into the housing of the smart phone, the smart phone can be operated with one hand.

As an example of this, JP-A 2001-189792 (Patent Document 1) discloses system for selecting an item or anchor point out of screen information with a touch sensor incorporated into the housing of a non-display screen part such as the rear side of the display screen which is normally not used as a sensor. Examples of the input device which realizes the touch sensor of Patent Document 1 include those employing capacitance system, resistance film system, optical system, electromagnetic induction system and piezoelectric sheet system.

Meanwhile, an example of the input device employing piezoelectric sheet system is disclosed by JP-A 2011-253517 (Patent Document 2). Unlike touch sensors employing capacitance system and resistance film system, a touch sensor employing piezoelectric sheet system can detect both pressure applied to the sensor and position information at the same time by itself and can contribute to the diversification of input information.

Patent Document 2 discloses an example of a piezoelectric sheet member making use of polylactic acid which is a piezoelectric polymer. As disclosed by Patent Document 2, the piezoelectric sheet comprising polylactic acid can be made flexible and is an excellent element capable of detecting position information and stress at the same time by itself. However, in order to obtain a sufficient electric output, the piezoelectric sheet must be bent to some extent with its stress at the time of input.

Although the piezoelectric sheet comprising polylactic acid generates an electric output with shearing stress applied to the sheet, a sufficient electric output cannot be obtained with tension or compression. Therefore, to obtain a large electric output, the sheet must be bent with pressing force in a direction perpendicular to the plane of the piezoelectric sheet.

For example, when it is considered that this piezoelectric sheet is attached to the housing on the rear side of a smart phone or integrated with the housing before use, it is difficult to bend the sheet spatially with pushing pressure applied to the sheet in the vertical direction, and a piezoelectric element which generates a sufficient electric output simply by rubbing the surface has been desired. Since the surface of the housing of a smart phone is not always flat and there are many 3-D irregularities in shape to ensure its design, the piezoelectric element for use in the smart phone has been desired to be flexible.

A piezoelectric fiber technology in which a piezoelectric polymer is twisted and oriented is disclosed by Japanese Patent No. 354028 (Patent Document 3). A piezoelectric fiber disclosed by Patent Document 3 obtains an electric output with the tension and compression of the fiber by twisting the fiber by a special production method in advance. However, Patent Document 3 is silent about a technology for generating a sufficient electric output with shearing stress produced by rubbing the surface of the fiber and extracting the electric output.

Therefore, it is extremely difficult to extract a sufficient electric output only with relatively small application stress produced by rubbing the surface with a finger by incorporating this piezoelectric fiber element into the housing of the above-mentioned smart phone.

In general, it is known that a polylactic acid fiber which has been uniaxially stretched and oriented rarely produces polarization by stretching in the stretching axis and a direction perpendicular to the stretching axis and compression stress with the result that an electric output is hardly obtained with relatively small application stress produced by rubbing the surface with a finger.

Meanwhile, it is known that polarization is produced by applying force in a direction neither parallel nor perpendicular to the stretching axis of the polylactic acid piezoelectric fiber, that is, shearing stress so that the polylactic acid piezoelectric fiber develops a function as a piezoelectric body.
(Patent Document 1) JP-A 2001-189792
(Patent Document 2) JP-A 2011-253517
(Patent Document 3) Japanese Patent No. 3540208

JP S60 139845 A discloses a woven fabric comprising a conductive fiber and an insulating fiber, wherein the conductive fiber and insulating fiber are arranged alternately. The woven fabric electrifies when an electrical point is formed in the fabric by a movement of the conductive fiber.

JP 2005 060922 A discloses a textile product for use in a paper machine, having a monofilament or a profiled structure as support element on which is arranged a layered sensor for measuring pressure and/or temperature, and is characterized in that the sensor is constituted from at least three layers, the second layer having piezoelectric properties and the layers in contact against the second layer forming electrodes that are couplable or coupled to an analysis device.

US 2011/260584 A1 discloses piezoelectric fibers that include a polypeptide wherein molecules of the polypeptide have electric dipole moments that are aligned such that the piezoelectric fiber provides a piezoelectric effect at an operating temperature. A piezoelectric component provides a plurality of piezoelectric fibers, each comprising an organic polymer. A method of producing piezoelectric fibers includes electrospinning a polymer solution to form a fiber and winding the fiber onto a rotating target in which the rotating target is electrically grounded.
US 2013/106245 A1 discloses fiber-reinforced composites acting as an actuator, as a sensor and/or as a generator and a manufacturing process. In the fiber-reinforced composites at least one piezoelectric element is fixed and positioned by fibers or yarn within a fiber structure or by means of fibers or yarn to a fiber structure. Flexible, electrically conductive connections which can be contacted from outside the fiber-reinforced composite are led at and/or within the fiber structure to electric connector contacts of the at least one piezoelectric element. One or more piezoelectric elements, electrically conductive connections and the fiber structure are embedded in a matrix material.
JP 2000 144545 A discloses producing a piezoelectric material said to be capable of producing piezoelectric properties by a tension applied in the axial direction by applying specific twists in the axial direction to a fibrous material comprising a piezoelectric polymer. The production method is: twists are applied through a driving unit to a fiber yarn continuously delivered from a yarn tube and comprising a piezoelectric polymer such as polylactic acid in the same direction or alternately with the opposite direction or in the direction randomly at a twisting angle within the range of 10°-60° from the axial direction and the yarn is then passed through a dry heating bath and a roller bath and wound with a winder to produce a piezoelectric material.

### DISCLOSURE OF THE INVENTION

### Problem to Be Solved by the Invention

It is an object of the invention to provide a fibrous piezoelectric element which can extract an electric output with relatively small application stress produced by rubbing the surface with a finger.

### Means for Solving the problems

The inventors of the present invention found that a combination of two conductive fibers and one piezoelectric fiber may function as a piezoelectric element and accomplished the present invention. The present invention is defined by the claims.

### BRIEF DESCRIPTION OF THE DRAWINGS

Fig. 1 is a schematic view of the piezoelectric element of Example 1 which is an example of the constitution of the piezoelectric element of the present disclosure;
Fig. 2 is a schematic view of an evaluation system for the piezoelectric elements of Examples 1 and 7 and Comparative Example 1;
Fig. 3 is a graph showing the piezoelectric characteristics of the piezoelectric element of Example 1;
Fig. 4 is a schematic view of the piezoelectric element of Example 2 which is an example of the constitution of the piezoelectric element of the present disclosure;
Fig. 5 is a schematic view of an evaluation system for the piezoelectric element of Example 2;
Fig. 6 is a graph showing the piezoelectric characteristics of the piezoelectric element of Example 2;
Fig. 7 is a schematic view of the piezoelectric element of Example 3 which is an example of the constitution of the piezoelectric element of the present invention;
Fig. 8 is a graph showing the piezoelectric characteristics (rubbing) of the piezoelectric element of Example 3;
Fig. 9 is a graph showing the piezoelectric characteristics (bending) of the piezoelectric element of Example 3;
Fig. 10 is a schematic view of the piezoelectric element of Example 4 which is an example of the constitution of the piezoelectric element of the present invention;
Fig. 11 is a graph showing the piezoelectric characteristics of the piezoelectric element of Example 4;
Fig. 12 is a schematic view of the piezoelectric element of Example 5 which is an example of the constitution of the piezoelectric element of the present invention;
Fig. 13 is a schematic view of the piezoelectric element of Example 6 which is an example of the constitution of the piezoelectric element of the present invention; and
Fig. 14 is a graph showing the piezoelectric characteristics of the piezoelectric element of Example 6.

### Effect of the Invention

The piezoelectric element of the present invention is flexible and can extract an electric output simply by rubbing the surface of the piezoelectric element with a finger.

The piezoelectric element of the present invention can be advantageously used as a touch sensor. By incorporating the piezoelectric element of the present invention into the housing of a smart phone, the smart phone can be operated with one hand. Since the piezoelectric element of the present invention is in the form of a flexible fiber, it can be woven or knitted to produce cloth, whereby a cloth touch panel which can be folded like a handkerchief can be materialized. Further, since the piezoelectric element of the present invention can extract an electric output simply by rubbing, it can be used in a micro-generator.

Further, since the piezoelectric element of the present invention changes its shape when an electric signal is applied thereto, it can be used as an actuator as well. For example, by applying an electric signal to a cloth piezoelectric element, an object mounted on the surface of the cloth can be moved or wrapped. Also, an electric signal to be applied to the piezoelectric element constituting cloth can be controlled.

### BEST MODE FOR CARRYING OUT THE INVENTION

The present invention is attained by a piezoelectric element according to the independent device claim 1. The constitution of the piezoelectric element will be described hereinbelow.

### (conductive fiber)

The diameter of the conductive fiber is preferably 1 µm to 10 mm, more preferably 10 µm to 5 mm, much more preferably 0.1 to 2 mm. When the diameter is small, strength degrades and handling becomes difficult. When the diameter is large, flexibility is sacrificed. The sectional shape of the conductive fiber is preferably circular or elliptic from the viewpoints of the design and production of the piezoelectric element but not limited to these.

Any material may be used as the material of the conductive fiber if it exhibits conductivity. A conductive polymer is preferred as it needs to be formed fibrous. As the conductive polymer may be used polyaniline, polyacetylene, poly(p-phenylene vinylene), polypyrrole, polythiophene, poly(p-phenylene sulfide) and carbon fiber. A conductive polymer comprising a polymer as a matrix and a fibrous or granular conductive filler may be used. From the viewpoints of flexibility and the stability of electric characteristics in the longitudinal direction, a carbon fiber is preferred. To extract an electric output from the piezoelectric polymer efficiently, electric resistance is preferably low with a volume resistivity of preferably 10⁻¹ Ω·cm or less, more preferably 10⁻² Ω·cm or less, much more preferably 10⁻³ Ω·cm or less.

An ordinary carbon fiber is generally a multifilament which is a bundle of filaments. This multifilament may be used, or only one monofilament may be used. Use of a multifilament is preferred from the viewpoint of the stability of electric characteristics in the longitudinal direction. The diameter of the monofilament is 1 to 5,000 µm, preferably 2 to 100 µm, more preferably 3 to 10 µm. The filament count is preferably 10 to 100,000, more preferably 100 to 50,000, much more preferably 500 to 30,000.

### (piezoelectric fiber)

The piezoelectric fiber is a fiber having piezoelectric properties. The piezoelectric fiber comprises polylactic acid as the main component. Polylactic acid is easily oriented by stretching after melt spinning to exhibit piezoelectric properties and is excellent in productivity as it does not require an electric field orientation treatment which is required for vinylidene polyfluoride. Further, since the piezoelectric fiber comprising polylactic acid has small polarization with tension or compression stress in the axial direction, it is difficult to make it function as a piezoelectric element. However, this is preferred for the piezoelectric element of the present invention having a constituent body which readily applies shearing stress to a piezoelectric polymer since it obtains a relatively large electric output with shearing stress.

The piezoelectric polymer comprises polylactic acid as the main component. The expression "as the main component" means that the content of polylactic acid is preferably 90 mol% or more, more preferably 95 mol% or more, much more preferably 98 mol% or more.

As the polylactic acid, there are poly-L-lactic acid obtained by polymerizing L-lactic acid or L-lactide, poly-D-lactic acid obtained by polymerizing D-lactic acid or D-lactide and stereocomplex polylactic acid having the hybrid structure of these according to the crystal structure. Any polylactic acid is acceptable if it exhibits piezoelectric properties. From the viewpoint of high piezoelectricity, poly-L-lactic acid and poly-D-lactic acid are preferred. Since the polarizations of poly-L-lactic acid and poly-D-lactic acid are opposite to each other with respect to the same stress, it is possible to use a combination of these according to purpose. The optical purity of polylactic acid is preferably 99 % or more, more preferably 99.3 % or more, much more preferably 99.5 % or more. When the optical purity is lower than 99 %, piezoelectricity may significantly drop, thereby making it difficult to obtain a sufficient electric output with rubbing force to the surface of the piezoelectric element. Preferably, the piezoelectric polymer comprises poly-L-lactic acid or poly-D-lactic acid as the main component, and the optical purities of these components are 99 % or more.

Preferably, the piezoelectric polymer is uniaxially oriented in the fiber axis direction of a covered fiber and contains a crystal. More preferably, it is uniaxially oriented polylactic acid having a crystal. This is because polylactic acid exhibits great piezoelectric properties in the crystalline state and the uniaxially oriented state.

Since polylactic acid is a polyester which is hydrolyzed relatively quickly, when it has a problem with moist heat resistance, a known hydrolysis inhibitor such as isocyanate compound, oxazoline compound, epoxy compound or carbodiimide compound may be added. An antioxidant such as a phosphoric acid-based compound, plasticizer and optical deterioration inhibitor may be added as required to improve physical properties.

Further, polylactic acid may be used as an alloy with another polymer. Polylactic acid is used as the main piezoelectric polymer, it is contained in an amount of preferably at least 50 wt% or more, more preferably 70 wt% or more, most preferably 90 wt% or more based on the total weight of the alloy.

In the case of a polylactic acid alloy, preferred examples of a polymer other than polylactic acid include polybutylene terephthalate, polyethylene terephthalate, polyethylene naphthalate copolymers and polymethacrylate. However, the polymer is not limited to these and any polymer may be used as long as a piezoelectric effect which is the object of the present invention is obtained.

The piezoelectric fiber is generally a multifilament which is a bundle of filaments. This multifilament may be used, or only one monofilament may be used. Use of the multifilament is preferred from the viewpoint of the stability of piezoelectric characteristics in the longitudinal direction. The diameter of the monofilament is 1 to 5,000 µm, preferably 5 to 500 µm. It is more preferably 10 to 100 µm. The filament count is preferably 1 to 100,000, more preferably 10 to 50,000, much more preferably 100 to 10,000.

In order to produce a piezoelectric fiber from this piezoelectric polymer, any known technique for fiberizing a polymer may be employed as long as the effect of the present invention is obtained. Examples of the technique include one in which a piezoelectric polymer is extrusion molded to be fiberized, one in which a piezoelectric polymer is melt spun to be fiberized, one in which a piezoelectric polymer is fiberized by dry or wet spinning, and one in which a piezoelectric polymer is fiberized by electrostatic spinning. As for these spinning conditions, a known technique may be used according to the piezoelectric polymer in use, and a melt spinning technique which facilitates industrial-scale production may be generally employed.

As described above, when the piezoelectric polymer is polylactic acid, it exhibits great piezoelectric properties if it is uniaxially oriented and contains a crystal. Therefore, its fiber is preferably stretched.

### (contact points)

Two conductive fibers and one piezoelectric fiber need to have contact points between them. These fibers may have contact points between them in any manner as long as these fibers are in contact with each other. For example, two conductive fibers are arranged parallel to each other and one piezoelectric fiber intersects with the two conductive fibers. Further, two conductive fibers are arranged as warps (or wefts) and one piezoelectric fiber is arranged as a weft (or a warp). In this case, the two conductive fibers are preferably not in contact with each other and an insulating material, for example, a polyester fiber having insulating properties is interposed between the two conductive fibers, or only the easy contact surfaces of the conductive fibers are covered with an insulating material and the conductive fibers are in direct contact with the piezoelectric fiber.

### (substantially on the same plane)

In the piezoelectric element of the present invention, two conductive fibers and one piezoelectric fiber are arranged substantially on the same plane. The expression "substantially on the same plane" means that the fiber axes of the three fibers are arranged substantially on a flat surface. The word "substantially" means that this includes a case where the intersections between the fibers become thick.

For example, when one piezoelectric fiber is arranged parallel to two parallel conductive fibers between the conductive fibers, they have contact points between them and are existent substantially on the same plane. Even when the fiber axis of one piezoelectric fiber is inclined so that it is not parallel to two parallel conductive fibers, they are substantially on the same plane. Further, even when one conductive fiber and one piezoelectric fiber are arranged parallel to each other and the other conductive fiber is arranged to intersect with the conductive fiber and the piezoelectric fiber, they are substantially on the same plane.

When they are not "substantially on the same plane", two conductive fibers have contact points at a position away from the surface of one piezoelectric fiber (excluding contact with the point symmetrical parts of the fiber axis of the piezoelectric fiber which is aligned and contacted) and the two conductive fibers do not intersect with each other.

When they are arranged substantially on the same plane, a fibrous or cloth piezoelectric element is easily formed by combining the piezoelectric units, and the degree of freedom in the shape design of a stress sensor or an actuator can be increased by using the fibrous or cloth piezoelectric element.

### (arrangement order)

In the piezoelectric unit a conductive fiber, a piezoelectric fiber and a conductive fiber are arranged in this order. When they are arranged in this order, the two conductive fibers of the piezoelectric unit are not in contact with each other, thereby making it possible for the piezoelectric unit to function effectively without using a technique for covering the conductive fibers with another means, for example, an insulating material. In the piezoelectric unit, preferably, the conductive fiber, the piezoelectric fiber and the conductive fiber are arranged substantially parallel to one another.

### (insulating fiber)

The piezoelectric unit of the present invention includes an insulating fiber which is preferably arranged such that the conductive fibers of this piezoelectric unit are not in contact with the conductive fibers and piezoelectric fiber of another piezoelectric unit. Since the arrangement order of the present invention is [conductive fiber/piezoelectric fiber/conductive fiber], the insulating fiber is arranged in the order of [insulating fiber/conductive fiber/piezoelectric fiber/conductive fiber] or [insulating fiber/conductive fiber/piezoelectric fiber/conductive fiber/insulating fiber].

Even when a plurality of piezoelectric units are used in combination by arranging the insulating fiber in the piezoelectric units as described above, it is possible to improve the performance (detection resolution of a detection sensor, small shape change of an actuator) of the piezoelectric element without contact between the conductive fibers.

This insulating fiber should have a volume resistivity of 10⁶ Ω·cm or more, preferably 10⁸ Ω·cm or more, more preferably 10¹⁰ Ω·cm or more.

Examples of the insulating fiber include polyester fibers, nylon fibers, acrylic fibers, polyethylene fibers, polypropylene fibers, vinyl chloride fibers, aramid fibers, polysulfone fibers, polyether fibers and polyurethane fibers, natural fibers such as silk, semi-synthetic fibers such as acetate fibers and regenerated fibers such as rayon and cupra. The insulating fiber is not limited to these and any known insulating fiber may be used. Further, these insulating fibers may be used in combination, and a combination of an insulating fiber and a fiber having no insulating properties may be used as a fiber having insulating properties as a whole .

In consideration of production ease, handling ease and strength, the insulating fiber preferably contains a polyethylene terephthalate-based fiber as the main component. The expression "as the main component" means that the fiber is contained in an amount of more than 50 %, preferably 75 % or more, more preferably 90 % or more, particularly preferably 99% or more, most preferably 100 % based on the insulating fiber. The expression "polyethylene terephthalate-based" means that polyethylene terephthalate is contained in the fiber in an amount of more than 50 %, preferably 75 % or more, more preferably 90 % or more, particularly preferably 99 % or more, most preferably 100 % based on the component constituting the fiber.

### (combination of piezoelectric units)

In the present invention, a woven or knitted fabric comprising a plurality of parallel piezoelectric units is preferred. Because of this, it is possible to improve the degree of freedom in the shape change (flexibility) of the piezoelectric element.

There is no limitation to the shape of this woven or knitted fabric as long as it comprises a plurality of parallel piezoelectric units and exhibits the function of a piezoelectric element. To obtain a woven or knitted form, it may be woven by using an ordinary loom or knitted by using a knitting machine.

Examples of the weave structure of the woven fabric include three foundation weaves which are plain weave, twill weave and satin weave, derivative weave, single double weaves such as warp-backed weave and weft-backed weave, and warp velvet.

As for the type of the knitted fabric, the knitted fabric may be a circular knitted fabric (weft knitted fabric) or warp knitted fabric. Preferred examples of the structure of the circular knitted fabric (weft knitted fabric) include plain stitch, rib stitch, interlock stitch, pearl stitch, tuck stitch, float stitch, single rib stitch, lace stitch and plating stitch. Examples of the structure of the warp knitted fabric include single Denbigh stitch, single atlas stitch, double cord stitch, half-tricot stitch, fleeced stitch and jacquard stitch. The number of layers may be one, or two or more. Further, a napped woven fabric or napped knitted fabric comprising a napped part composed of cut piles and/or loop piles and a ground structure part may also be used.

Although a bent part is existent in the piezoelectric fiber itself when the piezoelectric units are incorporated in a weave structure or knit structure, to develop the piezoelectric performance of the piezoelectric element efficiently, the bent part of the piezoelectric fiber is preferably small. Therefore, a woven fabric is more preferred than a knitted fabric.

From the viewpoint of balance among the strength, handling ease and production ease of the woven fabric, the piezoelectric units are arranged in the weft direction. Another fiber, for example, a polyethylene terephthalate-based fiber which is an insulating fiber is preferably arranged in the warp direction.

Even in this case, as described above, piezoelectric performance is developed efficiently when the bent part of the piezoelectric fiber is small. Therefore, as a weave structure, twill weave is more preferred than plain weave, and satin weave is more preferred than twill weave. When satin weave has a step number of 3 to 7, the weave structure can be kept and a high level of piezoelectric performance can be obtained advantageously.

Further, since the piezoelectric fiber tends to be electrified, an erroneous operation is apt to occur. In this case, the piezoelectric fiber which is to extract a signal may be earthed before use. As an earthing method, another conductive fiber is preferably arranged in addition to the conductive fiber for extracting a signal. In this case, the volume resistivity of the conductive fiber is preferably 10⁻¹ Ω·cm or less, more preferably 10⁻² Ω·cm or less, much more preferably 10⁻³ Ω·cm or less.

### (another piezoelectric element 1 - not claimed)

Also disclosed is a piezoelectric element as follows.
1. A piezoelectric element including a conductive fiber, a piezoelectric polymer which covers the surface of the conductive fiber and a surface conductive layer formed on the surface of the piezoelectric polymer.
2. The piezoelectric element in the above paragraph 1, wherein the piezoelectric polymer comprises polylactic acid as the main component.
3. The piezoelectric element in the above paragraph 1 or 2, wherein the piezoelectric polymer comprises poly-L-lactic acid or poly-D-lactic acid as the main component, and the optical purities of these components are 99 % or more.
4. The piezoelectric element in the above paragraph 2 or 3, wherein the piezoelectric polymer is uniaxially oriented and contains a crystal.
5. The piezoelectric element in any one of the above paragraphs 1 to 4, wherein the conductive fiber is a carbon fiber.
6. The piezoelectric element in any one of the above paragraphs 1 to 5 which is a sensor for detecting stress applied to the piezoelectric element and/or the application position of stress.
7. The piezoelectric element in the above paragraph 6, wherein stress applied to the piezoelectric element to be detected is rubbing force to the surface of the piezoelectric element.

### (conductive fiber)

The diameter of the conductive fiber is preferably 1 µm to 10 mm, more preferably 10 µm to 5 mm, much more preferably 0.1 to 2 mm. When the diameter is small, strength degrades and handing becomes difficult. When the diameter is large, flexibility is sacrificed. The sectional shape of the conductive fiber is preferably circular or elliptic from the viewpoint of the design and production of the piezoelectric element. However, the sectional shape is not limited to these. Although the piezoelectric polymer and the conductive fiber are preferably adhered to each other as tightly as possible, an anchor layer or an adhesive layer may be formed between the conductive fiber and the piezoelectric polymer to improve adhesion between them.

Any material may be used as the material of the conductive fiber if it exhibits conductivity. A conductive polymer is preferred as it needs to be formed fibrous. As the conductive polymer may be used polyaniline, polyacetylene, poly(p-phenylene vinylene), polypyrrole, polythiophene, poly(p-phenylene sulfide) and carbon fiber. A conductive polymer comprising a polymer as a matrix and a fibrous or granular conductive filler may be used. From the viewpoints of flexibility and the stability of electric characteristics in the longitudinal direction, a carbon fiber is preferred.

To extract an electric output from the piezoelectric polymer efficiently, electric resistivity is preferably low with a volume resistivity of preferably 10⁻¹ Ω·cm or less, more preferably 10⁻² Ω·cm or less, much more preferably 10⁻³ Ω·cm or less.

An ordinary carbon fiber is generally a multifilament which is a bundle of filaments. This multifilament may be used, or only one monofilament may be used. Use of a multifilament is preferred from the viewpoint of the stability of electric characteristics in the longitudinal direction. The diameter of the monofilament is 1 to 5,000 µm, preferably 2 to 100 µm, more preferably 3 to 10 µm. The filament count is preferably 10 to 100,000, more preferably 100 to 50,000, much more preferably 500 to 30,000.

### (piezoelectric polymer)

The thickness of the piezoelectric polymer covering the conductive fiber is preferably 1 µm to 5 mm, more preferably 5 µm to 3 mm, much more preferably 10 µm to 1 mm, most preferably 20 µm to 0.5 mm. When the thickness is too small, a strength problem may occur, and when the thickness is too large, it may be difficult to extract an electric output.

As for the covering state of the conductive fiber with this piezoelectric polymer, the conductive fiber and a fiber composed of the piezoelectric polymer are preferably as concentric as possible in order to keep a constant distance between the conductive fiber and the surface conductive layer. Although the method of forming the conductive fiber and the fiber composed of the piezoelectric polymer is not particularly limited, there is one in which the conductive fiber on the inner side and the piezoelectric polymer on the outer side are co-extruded, melt spun and stretched. When the conductive fiber is a carbon fiber, a method in which the outer surface of the conductive fiber is covered with the piezoelectric polymer which has been melt extruded and stretching stress is applied to stretch and orient the piezoelectric polymer at the time of covering may be employed. Further, a method in which a fiber composed of a hollow stretched piezoelectric polymer is prepared and the conductive fiber is inserted into the fiber may also be used.

Moreover, a method in which the conductive fiber and a fiber composed of a stretched piezoelectric polymer are formed by separate steps and the fiber composed of a piezoelectric polymer is wound round the conductive fiber may be employed as well.

In this case, the conductive fiber is preferably covered with the above fiber to ensure that these fibers are arranged as concentrically as possible. For example, a method in which the conductive fiber on the inner side, the piezoelectric polymer and the surface conductive layer are co-extruded, melt spun and stretched may be employed to form three layers at a time.

When the conductive fiber and the fiber composed of a stretched piezoelectric polymer are formed by separate steps and polylactic acid is used as the piezoelectric polymer, as preferred spinning and stretching conditions, the melt spinning temperature is preferably 150 to 250°C, the stretching temperature is preferably 40 to 150°C, the draw ratio is preferably 1.1 to 5.0 times, and the crystallization temperature is preferably 80 to 170°C.

Although any polymer which exhibits piezoelectric properties, such as vinylidene polyfluoride or polylactic acid, may be used as the piezoelectric polymer, it preferably comprises polylactic acid as the main component. Polylactic acid is easily oriented by stretching after melt spinning to exhibit piezoelectric properties and is excellent in productivity as it does not require an electric field orientation treatment which is required for vinylidene polyfluoride. Further, since the piezoelectric fiber comprising polylactic acid has small polarization with tension or compression stress in the axial direction, it is difficult to make it function as a piezoelectric element. However, this is preferred for the piezoelectric element of the present disclosure having a constituent body which readily applies shearing stress to a piezoelectric polymer since it obtains a relatively large electric output with shearing stress.

When the piezoelectric polymer fiber is wound round the conductive fiber to cover it, a multifilament which is a bundle of filaments or a monofilament may be used as the piezoelectric polymer fiber.

To wind the piezoelectric polymer fiber round the conductive fiber, for example, the piezoelectric polymer fiber is formed into a braided tube and the conductive fiber as a core is inserted into the tube to be covered, or when the piezoelectric polymer fiber is to be braided to produce a braided cord, a braided cord which includes the conductive fiber as core yarn and the piezoelectric polymer fiber arranged around the core yarn is produced to cover the conductive fiber.

The single filament diameter is 1 µm to 5 mm, preferably 5 µm to 2 mm, more preferably 10 µm to 1 mm. The filament count is preferably 1 to 100,000, more preferably 50 to 50,000, much more preferably 100 to 20,000.

The piezoelectric polymer preferably comprises polylactic acid as the main component. The expression "as the main component" means that the content of polylactic acid is preferably 90 mol% or more, more preferably 95 mol% or more, much more preferably 98 mol% or more.

When a multifilament is used as the conductive fiber, the piezoelectric polymer may cover the multifilament in such a manner that it is in contact with at least part of the surface (fiber outer surface) of the multifilament, and may or may not cover the surfaces (fiber outer surfaces) of all the filaments constituting the multifilament. The covering state of each inside filament constituting the multifilament is suitably set in consideration of the performance and handling ease of the piezoelectric element.

As the polylactic acid, there are poly-L-lactic acid obtained by polymerizing L-lactic acid or L-lactide, poly-D-lactic acid obtained by polymerizing D-lactic acid or D-lactide and stereocomplex polylactic acid having the hybrid structure of these according to the crystal structure. Any polylactic acid is acceptable if it exhibits piezoelectric properties. From the viewpoint of high piezoelectricity, poly-L-lactic acid and poly-D-lactic acid are preferred. Since the polarizations of poly-L-lactic acid and poly-D-lactic acid are opposite to each other with respect to the same stress, it is possible to use a combination of these according to purpose. The optical purity of polylactic acid is preferably 99 % or more, more preferably 99.3 % or more, much more preferably 99.5 % or more. When the optical purity is lower than 99 %, piezoelectricity may significantly drop, thereby making it difficult to obtain a sufficient electric output by rubbing force to the surface of the piezoelectric element.

Preferably, the piezoelectric polymer comprises poly-L-lactic acid or poly-D-lactic acid as the main component, and the optical purities of these components are 99 % or more.

Preferably, the piezoelectric polymer is uniaxially oriented and contains a crystal. More preferably, it is uniaxially oriented polylactic acid having a crystal. This is because polylactic acid exhibits great piezoelectric properties in the crystalline state and the uniaxially oriented state.

Since polylactic acid is a polyester which is relatively quickly hydrolyzed, when it has a problem with moist heat resistance, a known hydrolysis inhibitor such as an isocyanate, epoxy or carbodiimide compound may be added. An antioxidant such as a phosphoric acid-based compound, plasticizer and optical deterioration inhibitor may be added as required to improve physical properties. Further, polylactic acid may be used as an alloy with another polymer. When polylactic acid is used as the main piezoelectric polymer, it is contained in an amount of preferably at least 50 wt% or more, more preferably 70 wt% or more, most preferably 90 wt% or more.

In the case of a polylactic acid alloy, preferred examples of a polymer other than polylactic acid include polybutylene terephthalate, polyethylene terephthalate, polyethylene naphthalate copolymers and polymethacrylate. However, the polymer is not limited to these and any polymer may be used as long as the effect of the present disclosure is obtained.

### (surface conductive layer)

Any material may be used as the material of the surface conductive layer if it exhibits conductivity. Examples of the material include coats of paste containing a metal such as silver or copper, vapor-deposited films of silver, copper and indiumtin oxide, and conductive polymers such as polyaniline, polyacetylene, poly(p-phenylene vinylene), polypyrrole, polythiophene, poly(p-phenylene sulfide) and carbon fiber. To keep high conductivity, the volume resistivity is preferably 10⁻¹ Ω·cm or less, more preferably 10⁻² Ω·cm or less, much more preferably 10⁻³ Ω·cm or less.

The thickness of this surface conductive layer is preferably 10 nm to 100 µm, more preferably 20 nm to 10 µm, much more preferably 30 nm to 3 µm. When the thickness is too small, conductivity degrades and an electric output may be hardly obtained and when the thickness is too large, flexibility may be lost.

The surface conductive layer may be formed on the entire surface of the piezoelectric polymer or discretely. Since this arrangement method may be designed according to purpose, this arrangement is not particularly limited. By arranging this surface conductive layer discretely and extracting an electric output from the discrete surface conductive layers, the strength and position of stress applied to the piezoelectric element can be detected.

In order to protect the surface conductive layer, that is, prevent the surface conductive layer which is the outermost layer from contact with a human hand, some protective layer may be formed. This protective layer is preferably insulating, more preferably made of a polymer from the viewpoint of flexibility. As a matter of course, the protective layer is rubbed in this case and is not particularly limited if shearing stress reaches the piezoelectric polymer by this rubbing and can induce its polarization. The protective layer is not limited to a protective layer which is formed by coating a polymer but may be a film or a combination of films. An epoxy resin and an acrylic resin are preferably used for the protective layer.

The thickness of the protective layer should be as small as possible since shearing force can be easily transmitted to the piezoelectric polymer. However, when the thickness is too small, a problem such as destruction tends to occur. Therefore, it is preferably 10 nm to 200 µm, more preferably 50 nm to 50 µm, much more preferably 70 nm to 30 µm, most preferably 100 nm to 10 µm.

Although there is a case where only one piezoelectric element is used, a plurality of piezoelectric elements may be used in combination, woven or knitted into cloth, or braided. Thereby, a cloth or braided piezoelectric element can be obtained. To produce a cloth or braided piezoelectric element, as long as the object of the present disclosure is attained, a fiber other than the piezoelectric element may be used in combination to carry out mixing, interweaving or interknitting, or incorporated into the resin of the housing of a smart phone.

### (another piezoelectric element 2 - not claimed)

Also disclosed is a piezoelectric element as follows.
1. A piezoelectric element includes at least two covered fibers which are prepared by covering the surfaces of conductive fibers with a piezoelectric polymer and are arranged substantially parallel to each other, wherein the piezoelectric polymers on the surfaces are in contact with each other.
2. The piezoelectric element in the above paragraph 1, wherein the piezoelectric polymer comprises polylactic acid as the main component.
3. The piezoelectric element in the above paragraph 1 or 2, wherein the piezoelectric polymer comprises poly-L-lactic acid or poly-D-lactic acid as the main component and the optical purities of these components are 99 % or more.
4. The piezoelectric element in any one of the above paragraphs 1 to 3, wherein the piezoelectric polymer is uniaxially oriented and contains a crystal.
5. The piezoelectric element in any one of the above paragraphs 1 to 4, wherein the conductive fiber is a carbon fiber.
6. The piezoelectric element in any one of the above paragraphs 1 to 5 which is a sensor for detecting the size of stress applied to the piezoelectric element and/or the application position.
7. The piezoelectric element in the above paragraph 6, wherein stress applied to the piezoelectric element to be detected is rubbing force to the surface of the piezoelectric element.

### (covered fiber)

The piezoelectric element of the present disclosure includes at least two covered fibers prepared by covering the surfaces of conductive fibers with a piezoelectric polymer.

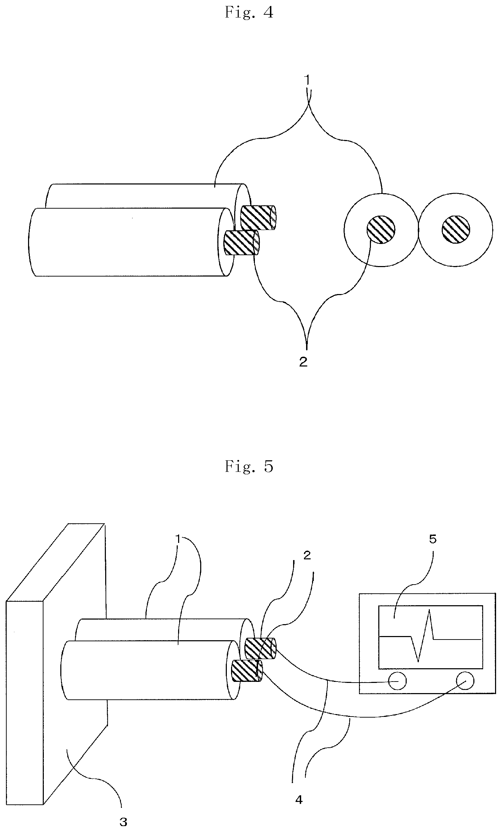

Fig. 4 is a schematic view showing the piezoelectric element of the present disclosure. In Fig. 4, reference numeral 1 denotes the piezoelectric polymer and 2 the conductive fiber.

Although the length of the piezoelectric element is not particularly limited, the piezoelectric element is produced continuously and then may be cut to a desired length before use. For the actual use of the piezoelectric element, the length is 1 mm to 10 m, preferably 5 mm to 2 m, more preferably 1 cm to 1 m. When the length is small, convenience that the piezoelectric element has a fibrous shape is lost and when the length is large, there occurs a problem such as a drop in electric output due to the resistance value of the conductive fiber.

### (conductive fiber)

Any material may be used as the material of the conductive fiber if it exhibits conductivity. A conductive polymer is preferred as it needs to be formed fibrous. As the conductive polymer may be used polyaniline, polyacetylene, poly(p-phenylene vinylene), polypyrrole, polythiophene, poly(p-phenylene sulfide) and carbon fiber. A conductive polymer comprising a polymer as a matrix and a fibrous or granular conductive filler may be used. From the viewpoints of flexibility and the stability of electric characteristics in the longitudinal direction, a carbon fiber is preferred.

To extract an electric output from the piezoelectric polymer efficiently, electric resistance is preferably low with a volume resistivity of preferably 10⁻¹ Ω·cm or less, more preferably 10⁻² Ω·cm or less, much more preferably 10⁻³ Ω·cm or less.

The diameter of the conductive fiber is preferably 1 µm to 10 mm, more preferably 10 µm to 5 mm, much more preferably 0.1 to 2 mm. When the diameter is small, strength degrades and handling becomes difficult. When the diameter is large, flexibility is sacrificed.

The sectional shape of the conductive fiber is preferably circular or elliptic from the viewpoints of the design and production of the piezoelectric element but not limited to these. As a matter of course, only one conductive fiber may be used, or a bundle of conductive fibers may be used.

An ordinary carbon fiber is generally a multifilament which is a bundle of filaments. This multifilament may be used, or only one monofilament may be used. Use of a multifilament is preferred from the viewpoint of the stability of electric characteristics in the longitudinal direction.

The diameter of the monofilament is 1 to 5,000 µm, preferably 2 to 100 µm, more preferably 3 to 10 µm. The filament count is preferably 10 to 100,000, more preferably 100 to 50,000, much more preferably 500 to 30,000.

### (piezoelectric polymer)

Although a polymer which exhibits piezoelectric properties such as vinylidene polyfluoride or polylactic acid may be used as the piezoelectric polymer, it preferably comprises polylactic acid as the main component. Polylactic acid is easily oriented by stretching after melt spinning to exhibit piezoelectric properties and is excellent in productivity as it does not require an electric field orientation treatment which is required for vinylidene polyfluoride. Further, since the piezoelectric fiber comprising polylactic acid has small polarization with tension or compression stress in the axial direction, it is difficult to make it function as a piezoelectric element. However, this is preferred for the piezoelectric element of the present disclosure having a constituent body which readily applies shearing stress to a piezoelectric polymer since it obtains a relatively large electric output with shearing stress.

The piezoelectric polymer preferably comprises polylactic acid as the main component. The expression "as the main component" means that the content of polylactic acid is preferably 90 mol% or more, more preferably 95 mol% or more, much more preferably 98 mol% or more.

As the polylactic acid, there are poly-L-lactic acid obtained by polymerizing L-lactic acid or L-lactide, poly-D-lactic acid obtained by polymerizing D-lactic acid or D-lactide, and stereocomplex polylactic having a hybrid structure of these according to the crystal structure. Any polylactic acid is acceptable if it exhibits piezoelectric properties. From the viewpoint of high piezoelectricity, poly-L-lactic acid and poly-D-lactic acid are preferred. Since the polarizations of poly-L-lactic acid and poly-D-lactic acid are opposite to each other with respect to the same stress, it is possible to use a combination of these according to purpose. The optical purity of polylactic acid is preferably 99 % or more, more preferably 99.3 % or more, much more preferably 99.5 % or more. When the optical purity is lower than 99 %, piezoelectricity may significantly drop, thereby making it difficult to obtain a sufficient electric output with rubbing force to the surface of the piezoelectric element. Preferably, the piezoelectric polymer comprises poly-L-lactic acid or poly-D-lactic acid as the main component and the optical purities of these components are 99 % or more.

Preferably, the piezoelectric polymer is uniaxially oriented in the fiber axis direction of the covered fiber and contains a crystal. More preferably, it is uniaxially oriented polylactic acid having a crystal. This is because polylactic acid exhibits great piezoelectric properties in the crystalline state and the uniaxially oriented state.

Since polylactic acid is a polyester which is relatively quickly hydrolyzed, when it has a problem with moist heat resistance, a known hydrolysis inhibitor such as isocyanate compound, oxazoline compound, epoxy compound or carbodiimide compound may be added. An antioxidant such as a phosphoric acid-based compound, plasticizer and optical deterioration inhibitor may be added as required to improve physical properties.

Further, polylactic acid may be used as an alloy with another polymer. When polylactic acid is used as the main piezoelectric polymer, it is contained in an amount of preferably at least 50 wt% or more, more preferably 70 wt% or more, most preferably 90 wt% or more.

In the case of a polylactic acid alloy, preferred examples of a polymer other than polylactic acid include polybutylene terephthalate, polyethylene terephthalate, polyethylene naphthalate copolymers and polymethacrylate. However, the polymer is not limited to these, and any polymer may be used as long as the effect of the present disclosure is obtained.

### (covering)

The surface of each conductive fiber is covered with the piezoelectric polymer. The thickness of the piezoelectric polymer covering the conductive fiber is preferably 1 µm to 10 mm, more preferably 5 µm to 5 mm, much more preferably 10 µm to 3 mm, most preferably 20 µm to 1 mm. When the thickness is too small, a strength problem may occur, and when the thickness is too large, it may be difficult to extract an electric output.

Although the piezoelectric polymer and the conductive fiber are preferably adhered to each other as tightly as possible, an anchor layer or an adhesive layer may be formed between the conductive fiber and the piezoelectric polymer to improve adhesion between them.

The covering method and the shape are not particularly limited as long as an electric output generated by application stress can be extracted.

For example, like the manufacture of an electric wire, the conductive fiber is covered with the molten piezoelectric polymer, piezoelectric polymer yarn is wound round the conductive fiber, or the conductive fiber is sandwiched between piezoelectric polymer films to be bonded. Three or more conductive fibers may be prepared when the conductive fibers are to be covered with the piezoelectric polymer as described above, or after only one conductive fiber is covered with the piezoelectric polymer, the surface of the piezoelectric polymer is bonded, thereby making it possible to obtain the piezoelectric element of the present disclosure. The adhesion method is not particularly limited but use of an adhesive or welding may be employed. The conductive fiber and the piezoelectric polymer may be merely adhered to each other.

As for the covering state of the conductive fiber with the piezoelectric polymer, although the shapes of the conductive fiber and the piezoelectric polymer are not particularly limited, for example, to obtain the piezoelectric element of the present disclosure by bonding a fiber prepared by covering one conductive fiber with the piezoelectric polymer afterward, it is preferred that they should be arranged as concentrically as possible in order to keep a constant distance between conductive fibers.

When a multifilament is used as the conductive fiber, the piezoelectric polymer may cover the multifilament in such a manner that it is in contact with at least part of the surface (fiber outer surface) of the multifilament, and may or may not cover the surfaces (fiber outer surfaces) of all the filaments constituting the multifilament. The covering state of each inside filament constituting the multifilament is suitably set in consideration of the performance and handling ease of the piezoelectric element.

The piezoelectric element of the present disclosure includes at least two conductive fibers, and the number of conductive fibers is not limited to two and may be more.

### (parallelism)

The conductive fibers are arranged substantially parallel to each other. The distance between the conductive fibers is preferably 1 µm to 10 mm, more preferably 5 µm to 5 mm, much more preferably 10 µm to 3 mm, most preferably 20 µm to 1 mm. When the distance is too small, a strength problem may occur and when the distance is too large, it may be difficult to extract an electric output. The expression "substantially parallel to each other" means that a plurality of conductive fibers are arranged without contacting each other, and the permissible deviation angle differs according to the fiber length of the conductive fiber.

### (contact)

The piezoelectric polymers on the surfaces of the covered fibers are in contact with each other. There is an example in which covered fibers, each comprising the conductive fiber as a core and the piezoelectric polymer as a cover layer, are in contact with each other at the surface cover layers. There is another example in which a plurality of conductive fibers arranged parallel to each other are sandwiched between two piezoelectric polymer films to be covered.

### (production method (i))

The piezoelectric element can be manufactured by bonding together at least two covered fibers prepared by covering the surfaces of conductive fibers with the piezoelectric polymer. Examples of this method are given below.
(i-1) A method comprising the steps of: coextruding a conductive fiber on the inner side and a piezoelectric polymer on the outer side, melt spinning the co-extruded product and stretching it.
(ii-2) A method comprising the steps of: melt extruding a piezoelectric polymer onto a conductive fiber to cover it and applying stretching stress at the time of covering to orient the piezoelectric polymer.
(iii-3) A method comprising the steps of: preparing a fiber composed of a hollow stretched piezoelectric polymer and inserting a conductive fiber into the fiber.
(iv-4) A method comprising the steps of: preparing a conductive fiber and a fiber composed of a stretched piezoelectric polymer by separate steps and winding the fiber composed of a piezoelectric polymer round the conductive fiber to cover the conductive fiber. In this case, the conductive fiber is preferably covered to ensure that both fibers are arranged as concentrically as possible.

In this case, as preferred spinning and stretching conditions when polylactic acid is used as the piezoelectric polymer, the melt spinning temperature is preferably 150 to 250°C, the stretching temperature is preferably 40 to 150°C, the draw ratio is preferably 1.1 to 5.0 times, and the crystallization temperature is preferably 80 to 170°C.

A multifilament which is a bundle of filaments or a monofilament may be used as the piezoelectric polymer fiber to be wound.

To wind the piezoelectric polymer fiber round the conductive fiber, for example, the fiber composed of a piezoelectric polymer is formed into a braided tube and the conductive fiber as a core is inserted into the tube to be covered, or when the fiber composed of a piezoelectric polymer is braided to produce a braided cord, a braided cord which includes the conductive fiber as core yarn and the piezoelectric polymer fiber arranged around the core yarn is produced to cover the conductive fiber. The single filament diameter of the fiber composed of a piezoelectric polymer is 1 µm to 5 mm, preferably 5 µm to 2 mm, more preferably 10 µm to 1 mm. The number of filaments is preferably 1 to 100,000, more preferably 50 to 50,000, much more preferably 100 to 20,000.

The piezoelectric element of the present disclosure can be obtained by bonding together a plurality of fibers prepared by covering the surfaces of the conductive fibers with the piezoelectric polymer according to the above method.

### (production method (ii))

The piezoelectric element of the present disclosure can be obtained by covering a plurality of conductive fibers arranged parallel to each other with a piezoelectric polymer. For example, the piezoelectric element of the present invention can be obtained by sandwiching a plurality of conductive fibers arranged parallel to each other between two piezoelectric polymer films. Also, a piezoelectric element having excellent flexibility can be obtained by cutting this piezoelectric element in a strip.

### (protective layer)

A protective layer may be formed on the outermost surface of the piezoelectric element of the present disclosure. This protective layer is preferably insulating, more preferably made of a polymer from the viewpoint of flexibility. As a matter of course, the protective layer is rubbed in this case, and the protective layer is not particularly limited if shearing stress produced by this rubbing reaches the piezoelectric polymer and can induce its polarization. The protective layer is not limited to one which is formed by coating a polymer but may be a film or a combination of films. An epoxy resin and an acrylic resin are preferably used for the protective layer.

The thickness of the protective layer should be as small as possible since shearing force can be easily transmitted to the piezoelectric polymer. When the thickness is too small, a problem such as the destruction of the protective layer tends to occur. Therefore, the thickness is preferably 10 nm to 200 µm, more preferably 50 nm to 50 µm, much more preferably 70 nm to 30 µm, most preferably 100 nm to 10 µm. The shape of the piezoelectric element can be formed by this protective layer.

### (a plurality of piezoelectric elements)

A plurality of piezoelectric elements may be used in combination before use. They may be arranged in one level one-directionally, stacked two-directionally, further woven or knitted into cloth, or braided. Thereby, a cloth or braided piezoelectric element can be obtained. To produce a cloth or braided piezoelectric element, as long as the object of the present invention is attained, a fiber other than the piezoelectric element may be used in combination to carry out mixing, interweaving or interknitting, or incorporated into the resin of the housing of a smart phone. When a plurality of the piezoelectric elements of the present invention are used in combination before use, as the piezoelectric elements of the present invention do not have an electrode on the surface, the arrangement and braiding of these can be selected from wide ranges.

### (application technology of piezoelectric element)

The piezoelectric element can be used as a sensor for detecting the size of stress produced by rubbing the surface of the piezoelectric element and/or the application position. The piezoelectric element of the present invention can extract an electric output when shearing stress is applied to the piezoelectric polymer by pressing other than rubbing as a matter of course.

The expression "application stress" means stress produced by rubbing with the surface of a finger as described in the object of the invention. The level of stress produced by rubbing with the surface of a finger is approximately 1 to 100 Pa. As a matter of course, it is needless to say that if the stress is larger than this range, it is possible to detect application stress and the application position thereof.

In the case of input with a finger, the piezoelectric element operates under a load of preferably 1 to 50 gf (100 to 500 mmN), more preferably 1 to 10 gf (10 to 100 mmN). As a matter of course, the piezoelectric element operates under a load larger than 50 gf (500 mmN) as described above.

The piezoelectric element can be used as an actuator by applying an electric signal thereto. Therefore, the piezoelectric element of the present invention can be used as a cloth actuator. In the actuator of the present invention, by controlling an electric signal to be applied, a concave or convex part can be formed in part of the surface of the cloth, or the whole cloth can be rolled. The actuator of the present invention can hold goods. When it is wound round a human body (arm, leg, hip, etc.), it can function as a supporter.

### EXAMPLES

The following examples are provided for the purpose of further illustrating the present invention but are in no way to be taken as limiting.

### Example 1 (reference)

### (production of polylactic acid)

0.005 part by weight of tin octylate was added to 100 parts by weight of L-lactide (manufactured by Musashino Chemical Laboratory, Ltd., optical purity of 100 %) to carry out a reaction in a nitrogen atmosphere at 180°C for 2 hours in a reactor equipped with a stirring blade, phosphoric acid was added in an amount which was 1.2 times the equivalent of tin octylate, the residual lactide was removed under a reduced pressure of 13.3 Pa, and the resulting product was formed into a chip to obtain poly-L-lactic acid (PLLA1) . The obtained PLLA1 had a weight average molecular weight of 152,000, a glass transition point (Tg) of 55°C and a melting point of 175°C.

### (evaluation of piezoelectric element)

The piezoelectric element was evaluated as follows in Example 1.

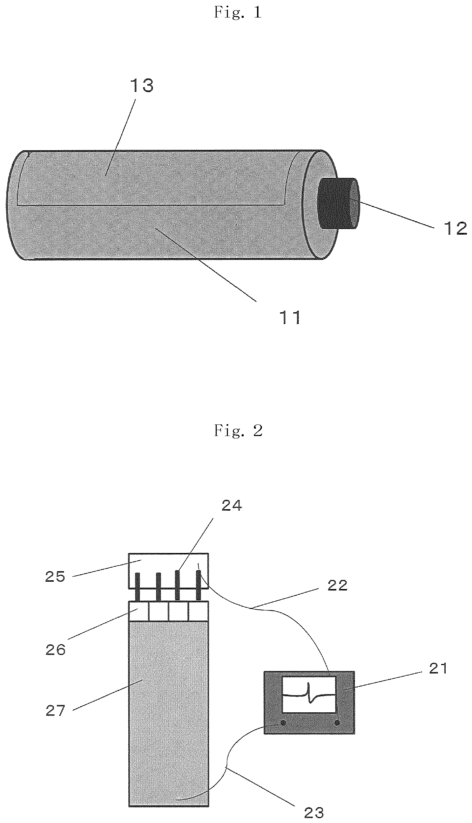

A finger was caused to touch the surface (gold deposited surface) of a surface conductive layer and to rub the surface at a velocity of about 0.5 m/s in a direction parallel to the longitudinal direction of the piezoelectric element so as to evaluate piezoelectric characteristics (substantially the same load of 50 gf (500 mmN) or less was set in all Examples and Comparative Examples). The evaluation system of Examples is shown in Fig. 2. For the evaluation of voltage, the DL6000 series digital oscilloscope (trade name of DL6000) of Yokokawa Electric Corporation was used.

### (production of piezoelectric element)

A carbon fiber multifilament manufactured by Toho Tenax Co., Ltd. (trade name of HTS40 3K) was used as the conductive fiber, covered with PLLA1 which was molten at a resin temperature of 200°C concentrically and cooled in air right away to obtain a covered fiber 1 having a length of 10 m.

The carbon fiber in the covered fiber 1 was the conductive fiber in the present disclosure. This carbon fiber was a multifilament consisting of 3,000 filaments having a diameter of 7.0 µm and having a volume resistivity of 1.6 x 10⁻³ Ω·cm. The diameter of this conductive fiber was 0.6 mm, and the thickness of the PLLA1 layer covering the conductive fiber was 0.3 mm (the diameter of the covered fiber 1 was 1.2 mm).

Then, this covered fiber 1 was cut to a fiber length of 12 cm, and both ends of only the carbon fiber (conductive fiber) on the inner side was removed 1 cm to prepare a covered fiber 2 having a length of the carbon fiber (conductive fiber) on the inner side of 10 cm and a length of the PLLA1 layer on the outer side of 12 cm. Thereafter, this covered fiber 2 was placed into a tensile tester set at a temperature of 80°C, and portions (1cm end portions) composed of only the PLLA1 layer at the both ends of the covered fiber 2 were held with a nip to stretch only the PLLA1 layer on the outer side uniaxially. The stretching rate was 200 mm/min, and the draw ratio was 3 times. Subsequently, while the covered fiber was held with the nip, the temperature was raised to 140°C to carry out a heat treatment for 5 minutes, and the covered fiber 2 was crystallized, quenched and taken out from the tensile tester.

The obtained covered fiber 2 was composed of two concentric layers and had a diameter of 0.8 mm and a thickness of the PLLA1 layer of 0.1 mm. Gold was coated on the half of the surface of this covered fiber to a thickness of about 100 nm by a vapor-deposition method to obtain the piezoelectric element of the present disclosure. The volume resistivity of the gold surface conductive layer was 1.0 x 10⁻⁴ Ω·cm.

Fig. 1 is a schematic view of this piezoelectric element. Four of the piezoelectric elements were prepared by the same method and arranged parallel to one another as shown in Fig. 2 to evaluate the piezoelectric characteristics.

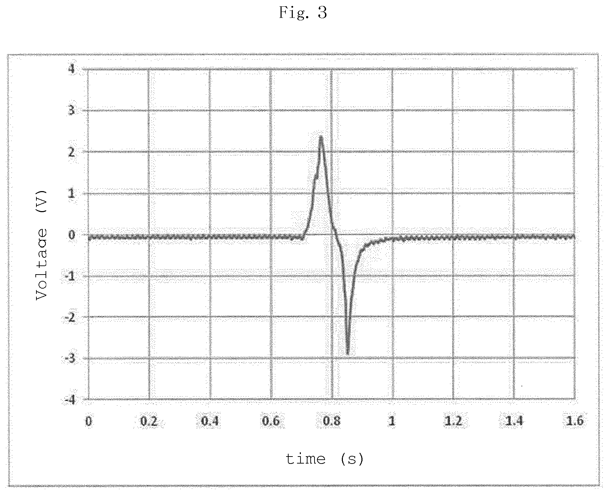

The evaluation result of the piezoelectric element is shown in Fig. 3. It was understood that an extremely large voltage of 2V or more was obtained simply by rubbing the surface. It was confirmed that this piezoelectric element functions as a piezoelectric element (sensor).

### Example 2 (reference)

### (production of polylactic acid)

0.005 part by weight of tin octylate was added to 100 parts by weight of L-lactide (manufactured by Musashino Chemical Laboratory, Ltd., optical purity of 100 %) to carry out a reaction in a nitrogen atmosphere at 180°C for 2 hours in a reactor equipped with a stirring blade, phosphoric acid was added in an amount which was 1.2 times the equivalent of tin octylate, the residual lactide was removed under a reduced pressure of 13.3 Pa, and the resulting product was formed into a chip to obtain poly-L-lactic acid (PLLA1) . The obtained PLLA1 had a weight average molecular weight of 152,000, a glass transition point (Tg) of 55°C and a melting point of 175°C.

### (evaluation of piezoelectric element)

The piezoelectric element was evaluated as follows in Example 2.

A finger was caused to touch the surface and to rub the surface at a velocity of about 0.5 m/s in a direction parallel to the longitudinal direction of the piezoelectric element so as to evaluate piezoelectric characteristics. The evaluation system of Example 2 is shown in Fig. 5. For the evaluation of voltage, the DL6000 series digital oscilloscope (trade name of DL6000) of Yokokawa Electric Corporation was used.

### (production of piezoelectric element)

A carbon fiber multifilament manufactured by Toho Tenax Co., Ltd. (trade name of HTS40 3K) was used as the conductive fiber, covered with PLLA1 which was molten at a resin temperature of 200°C concentrically and cooled in air right away to obtain a covered fiber 1 having a length of 10 m.

The carbon fiber in the covered fiber 1 was the conductive fiber in the present disclosure. This carbon fiber was a multifilament consisting of 3,000 filaments having a diameter of 7.0 µm and having a volume resistivity of 1.6 x 10⁻³ Ω·cm. The diameter of this conductive fiber was 0.6 mm, and the thickness of the PLLA1 layer covering the conductive fiber was 0.3 mm (the diameter of the covered fiber 1 was 1.2 mm).

Then, this covered fiber 1 was cut to a fiber length of 12 cm, and both ends of only the carbon fiber (conductive fiber) on the inner side was removed 1 cm to prepare a covered fiber 2 having a length of the carbon fiber (conductive fiber) on the inner side of 10 cm and a length of the PLLA1 layer on the outer side of 12 cm. Thereafter, this covered fiber 2 was placed into a tensile tester set at a temperature of 80°C, and portions (1cm end portions) composed of only the PLLA1 layer at the both ends of the covered fiber 2 were held with a nip to stretch only the PLLA1 layer on the outer side uniaxially. The stretching rate was 200 mm/min, and the draw ratio was 3 times. Subsequently, while the covered fiber was held with the nip, the temperature was raised to 140°C to carry out a heat treatment for 5 minutes, and the covered fiber 2 was crystallized, quenched and taken out from the tensile tester.

The obtained covered fiber 2 was composed of two concentric layers and had a diameter of 0.9 mm and a thickness of the PLLA1 layer of 0.15 mm. Further, two of the covered fibers 2 were welded together, and end portions of the piezoelectric polymers on the surfaces were removed to expose the conductive fibers so as to obtain a piezoelectric element shown in Fig. 4.

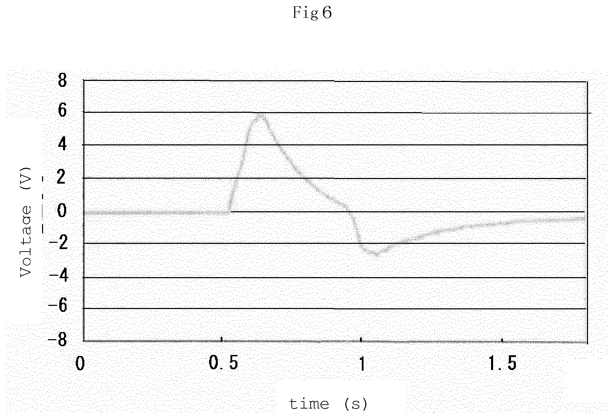

The piezoelectric characteristics of this piezoelectric element were evaluated with constitution shown in Fig. 5. The evaluation result of the piezoelectric element is shown in Fig. 6. It was found that an extremely large voltage of about 6V is obtained simply by rubbing the surface. It was confirmed that this piezoelectric element functioned as a piezoelectric element (sensor).

### Examples 3 to 7

### (production of polylactic acid)

Polylactic acid used in Examples 3 to 7 was produced by the following method in Examples 3 to 7.

0.005 part by weight of tin octylate was added to 100 parts by weight of L-lactide (manufactured by Musashino Chemical Laboratory, Ltd., optical purity of 100 %) to carry out a reaction in a nitrogen atmosphere at 180°C for 2 hours in a reactor equipped with a stirring blade, phosphoric acid was added in an amount which was 1.2 times the equivalent of tin octylate, the residual lactide was removed under a reduced pressure of 13.3 Pa, and the resulting product was formed into a chip to obtain poly-L-lactic acid (PLLA1) . The obtained PLLA1 had a weight average molecular weight of 152,000, a glass transition point (Tg) of 55°C and a melting point of 175°C.

### (evaluation of piezoelectric element)

The piezoelectric element was evaluated as follows in Examples 3 to 7.

The piezoelectric characteristics of the piezoelectric element were evaluated by transforming the piezoelectric element. The evaluation system is shown in Fig. 2. For the evaluation of voltage, the DL6000 series digital oscilloscope (trade name of DL6000) of Yokokawa Electric Corporation was used.

The piezoelectric fiber, the conductive fiber and the insulating fiber used in Examples 3 to 7 were manufactured by the following methods.

### (piezoelectric fiber)

PLLA1 molten at 240°C was discharged from a cap having 24 holes at a rate of 20 g/min and taken up at a rate of 887 m/min. This unstretched multifilament yarn was stretched to 2.3 times at 80°C and heat set at 100°C to obtain multifilament uniaxially stretched yarn 1 having a fineness of 84 dTex/24 filaments. 8 of the multifilament uniaxially stretched yarns were bundled to obtain a piezoelectric fiber 1.

### (conductive fiber)

A carbon fiber multifilament manufactured by Toho Tenax Co., Ltd. (trade name of HTS40 3K) was used as a conductive fiber 1. This conductive fiber 1 was a multifilament consisting of 3,000 filaments having a diameter of 7.0 µm and having a volume resistivity of 1.6 x 10⁻³ Ω·cm.

### (insulating fiber)

PET1 molten at 280°C was discharged from a cap having 48 holes at a rate of 45 g/min and taken up at a rate of 800 m/min. This unstretched yarn was stretched to 2.5 times at 80°C and heat set at 180°C to obtain multifilament stretched yarn having a fineness of 167 dTex/48 filaments. 4 of the multifilament stretched yarns were bundled to obtain an insulating fiber 1.

### Example 3

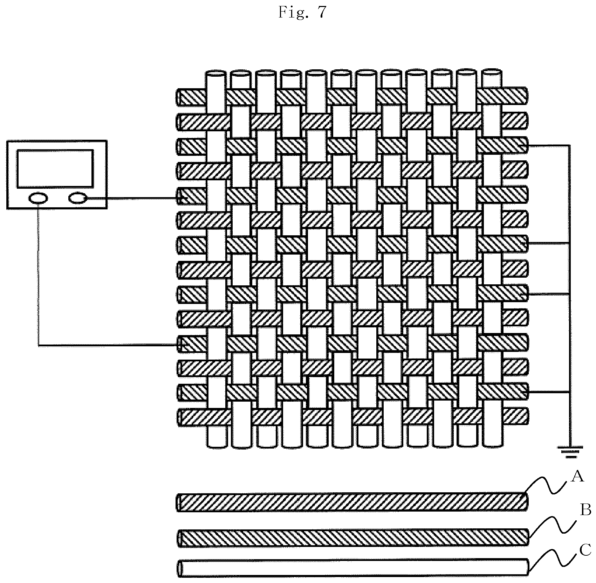

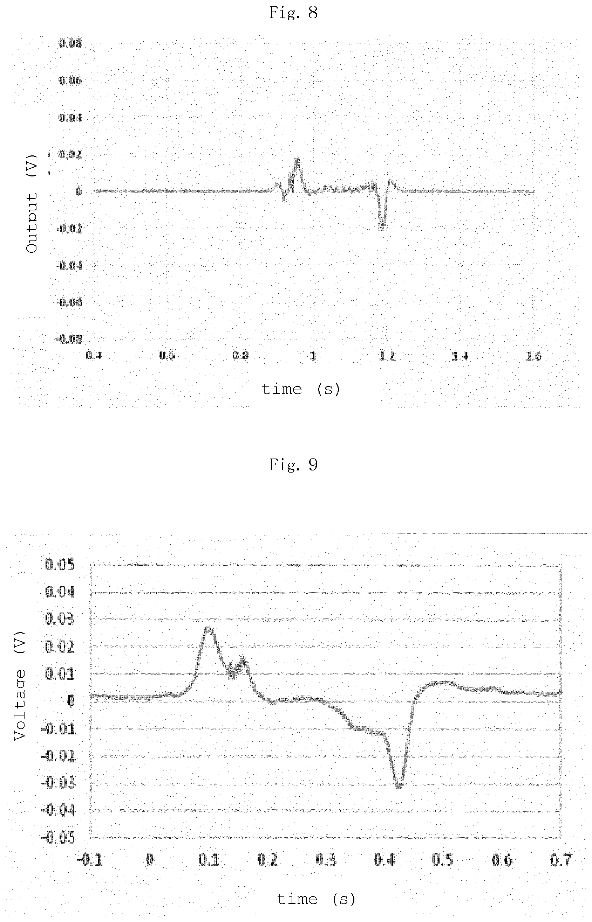

As shown in Fig. 7, a plain woven fabric was manufactured by arranging the insulating fiber 1 as a warp and the piezoelectric fiber 1 and the conductive fiber 1 alternately as wefts. A pair of the conductive fibers sandwiching the piezoelectric fiber in the plain woven fabric were connected as signal lines to an oscilloscope, and the other conductive fibers are connected to an earth. By rubbing the piezoelectric fiber sandwiched between the conductive fibers connected to the signal lines with a finger, a voltage signal shown in Fig. 8 was obtained. By bending the fibers, a voltage signal shown in Fig. 9 was obtained. Thus, it was confirmed that this plain woven fabric functioned as a piezoelectric element (sensor).

### Example 4

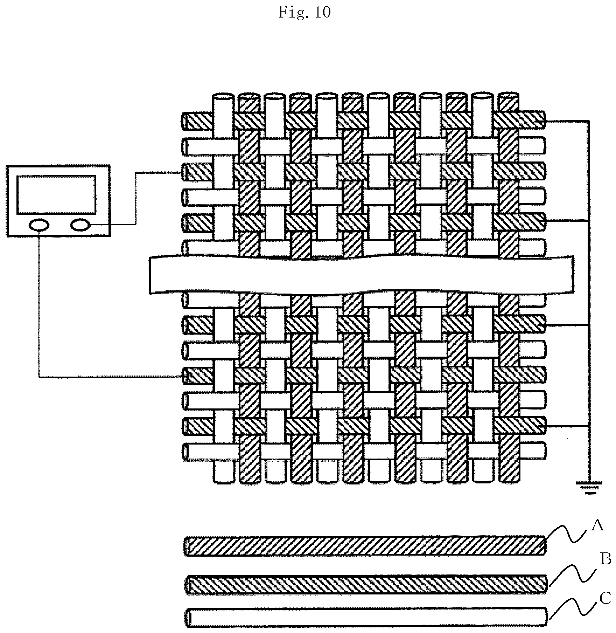

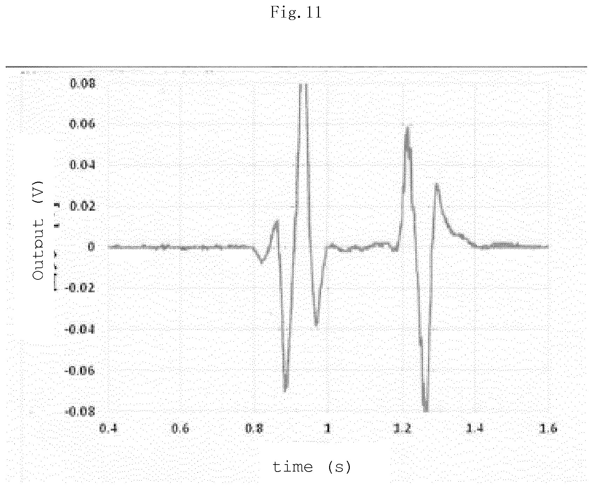

A plain woven fabric was manufactured by arranging the piezoelectric fiber 1 and the insulating fiber 1 alternately as warps and the conductive fiber 1 and the insulating fiber 1 alternately as wefts as shown in Fig. 10. A pair of conductive fibers which were 20 mm apart from each other in this woven fabric were connected as signal lines to an oscilloscope and the other conductive fibers were connected to an earth. By rubbing the piezoelectric fiber sandwiched between the conductive fibers connected to the signal lines with a finger, a voltage signal shown in Fig. 11 was obtained. It was confirmed that this plain woven fabric functioned as a piezoelectric element (sensor).

### Example 5

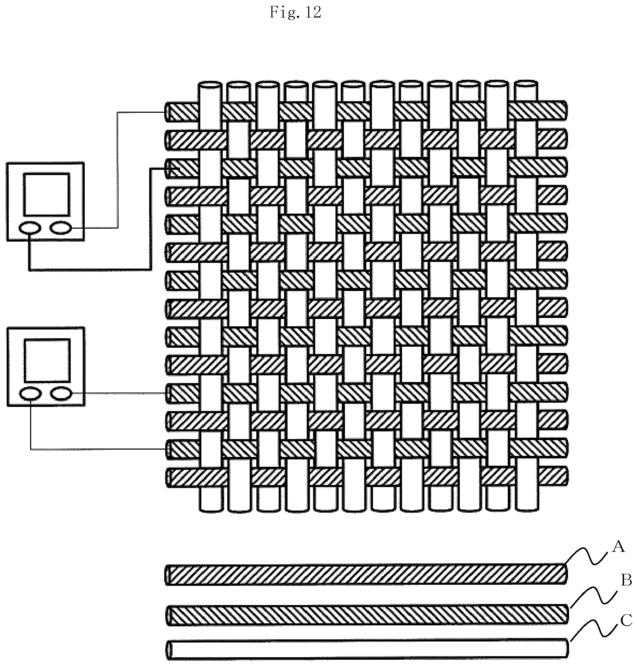

A plain woven fabric was manufactured by arranging the insulating fiber 1 as a warp and the piezoelectric fiber 1 and the conductive fiber 1 alternately as wefts as shown in Fig. 12. When a pair of conductive fibers sandwiching the piezoelectric fiber close to the both ends of this woven fabric were connected as signal lines to a voltage source and a voltage was applied to this plain woven fabric, the whole woven fabric was twisted. It was confirmed that this plain woven fabric functioned as a piezoelectric element (actuator).

### Example 6

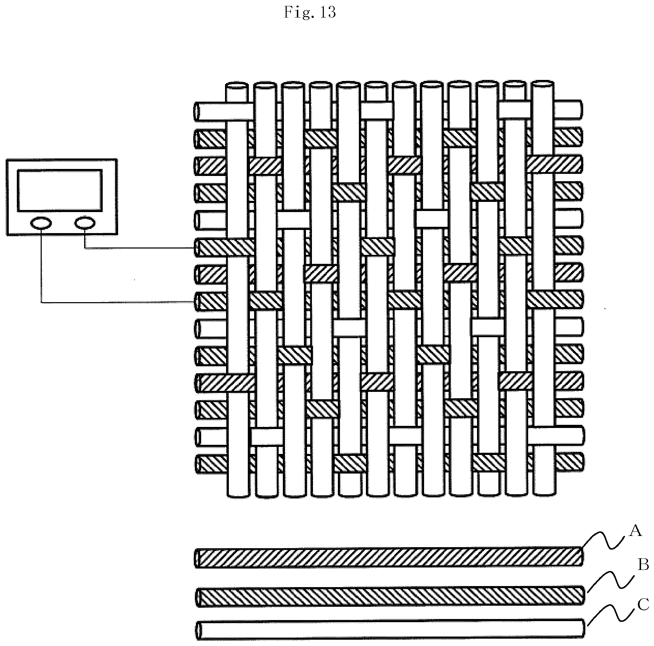

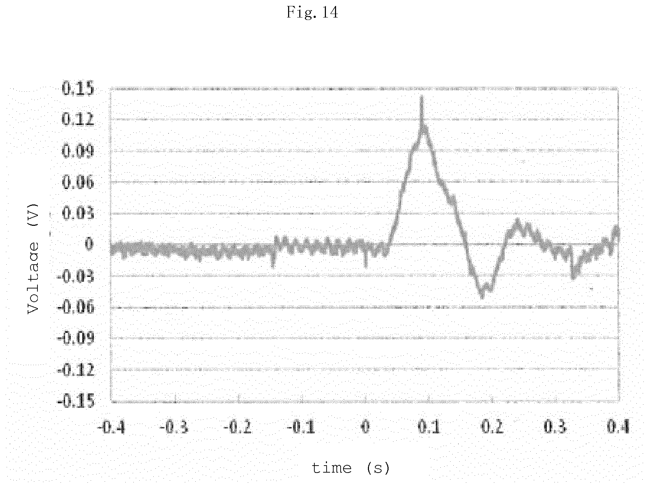

A satin woven fabric was manufactured by arranging the insulating fiber 1 as a warp and the insulating fiber 1, the conductive fiber 1, the piezoelectric fiber 1 and the conductive fiber 1 as wefts in this order as shown in Fig. 13. When a pair of the conductive fibers sandwiching the piezoelectric fiber of this woven fabric were connected as signal lines to an oscilloscope and the woven fabric was twisted, a voltage signal shown in Fig. 14 was obtained. It was confirmed that this satin woven fabric functioned as a piezoelectric element (sensor).

### Example 7 (reference)

Two braids were manufactured by using the HTS40 3K which is a carbon fiber multifilament manufactured by Toho Tenax Co., Ltd. as a core and multifilament uniaxially stretched yarn 1 as a braided cord.

These two braids were welded together by melting part of the fiber surface of the multifilament uniaxially stretched yarn using dichloromethane to obtain a piezoelectric element shown in Fig. 1.

The piezoelectric characteristics of this piezoelectric element were evaluated with constitution shown in Fig. 2.

It was found that an extremely large voltage of 5V could be obtained by rubbing the surface of this piezoelectric element, and it was confirmed that this piezoelectric element functioned as a piezoelectric element (sensor).

### Comparative Example 1

PLLA1 was molded at a resin temperature of 200°C by using a film melt extruder having a T die and quenched with a 40°C cooling roll to obtain a unstretched film. Subsequently, the film was stretched in a transverse direction at a draw ratio of 2.5 times and 80°C by using a tenter type transversely stretching machine and then crystallized in a heat setting zone at 140°C to obtain a stretched film having a width of 70 cm. This film was cut to a width of 1 cm and a length of 10 cm, and gold was vapor deposited on the both sides thereof to manufacture a piezoelectric element. The volume resistivity of the gold surface conductive layer was 1.0 x 10⁻⁴ Ω·cm. This piezoelectric element was evaluated in the same manner as in Example 1 except that the piezoelectric element was changed to this film piezoelectric element in Fig. 2.

When this piezoelectric element was evaluated, it was found that only a voltage lower than about 0.1V was obtained and that the rubbing force of the surface of the piezoelectric element could not be completely converted into voltage. It was confirmed that this piezoelectric element could not function as a piezoelectric element (sensor) which is the object of the present invention.

### Explanation of symbols in Figs. 1 and 2

- 11: piezoelectric polymer
- 12: conductive fiber
- 13: surface conductive layer
- 21: oscilloscope
- 22: wiring for evaluation
- 23: wiring for evaluation
- 24: conductive fiber
- 25: metal electrode
- 26: piezoelectric polymer
- 27: surface conductive layer

### Explanation of symbols in Fig. 4 and 5

- 1: piezoelectric polymer
- 2: conductive fiber
- 3: iezoelectric element fixing plate
- 4: wiring for evaluation
- 5: oscilloscope

### Explanation of symbols in Figs. 7, 10, 12 and 13

- A: piezoelectric fiber
- B: conductive fiber
- C: insulating fiber

## Claims

1. A piezoelectric element comprising a piezoelectric unit, **characterized in that** the piezoelectric unit includes two conductive fibers (B) and one piezoelectric fiber (A), arranged in the order a conductive fiber (B), a piezoelectric fiber (A) and a conductive fiber (B), all of which are arranged substantially on the same plane while they have contact points between them,
wherein the piezoelectric fiber (A) comprises polylactic acid as the main component.

2. The piezoelectric element according to claim 1, wherein the piezoelectric unit includes a conductive fiber (B), a piezoelectric fiber (A) and a conductive fiber (B) all of which are arranged substantially parallel to one another.

3. The piezoelectric element according to claim 1, wherein the piezoelectric unit includes an insulating fiber (C) which is arranged such that the conductive fibers (B) in the piezoelectric unit are not in contact with conductive fibers (B) and a piezoelectric fiber (A) in another piezoelectric unit.

4. The piezoelectric element according to claim 1, wherein the piezoelectric fiber (A) comprises poly-L-lactic acid or poly-D-lactic acid as the main component and the optical purities of these components are 99 % or more.

5. The piezoelectric element according to claim 1, wherein the piezoelectric fiber (A) is uniaxially oriented and contains a crystal.

6. The piezoelectric element according to claim 1, wherein the conductive fiber (B) is a carbon fiber.

7. The piezoelectric element according to claim 3, wherein the insulating fiber (C) comprises a polyethylene terephthalate-based fiber as the main component.

8. The piezoelectric element according to claim 2 which is a woven or knitted fabric comprising a plurality of parallel piezoelectric units.

9. The piezoelectric element according to claim 8 which is a woven fabric comprising a plurality of parallel piezoelectric units and having a satin weave structure.

10. The piezoelectric element according to claim 9, wherein the piezoelectric units are arranged in the weft direction.

11. The piezoelectric element according to claim 9, wherein the step number of a piezoelectric fiber (A) in the piezoelectric unit is 3 to 7.

12. The piezoelectric element according to any one of claims 1 to 11 which is a sensor for detecting the size of stress applied to the piezoelectric element and/or the application position.

13. The piezoelectric element according to claim 12, wherein stress applied to the piezoelectric element to be detected is rubbing force to the surface of the piezoelectric element.

14. The piezoelectric element according to any one of claims 1 to 11 which is an actuator that changes its shape according to an electric signal applied to the piezoelectric element.

## Patentansprüche

1. Piezoelektrisches Element, das eine piezoelektrische Einheit umfasst, **dadurch gekennzeichnet, dass** die piezoelektrische Einheit zwei leitfähige Fasern (B) und eine piezoelektrische Faser (A) einschließt, die in der Reihenfolge von einer leitfähigen Faser (B), einer piezoelektrischen Faser (A) und einer leitfähigen Faser (B) angeordnet sind, von denen alle im Wesentlichen in derselben Ebene angeordnet sind, während sie Kontaktpunkte zwischen sich haben, wobei die piezoelektrische Faser (A) Polymilchsäure als Hauptkomponente umfasst.

2. Piezoelektrisches Element nach Anspruch 1, wobei die piezoelektrische Einheit eine leitfähige Faser, eine piezoelektrische Faser (A) und eine leitfähige Faser (B) einschließt, von denen alle im Wesentlichen parallel zueinander angeordnet sind.

3. Piezoelektrisches Element nach Anspruch 1, wobei die piezoelektrische Einheit eine isolierende Faser (C) einschließt, die so angeordnet ist, dass die leitfähigen Fasern (B) in der piezoelektrischen Einheit nicht in Kontakt mit leitfähigen Fasern (B) und einer piezoelektrischen Faser (A) in einer anderen piezoelektrischen Einheit sind.

4. Piezoelektrisches Element nach Anspruch 1, wobei die piezoelektrische Faser (A) Poly-L-Milchsäure oder Poly-D-Milchsäure als Hauptkomponente umfasst und die optischen Reinheiten dieser Komponenten 99 % oder mehr sind.

5. Piezoelektrisches Element nach Anspruch 1, wobei die piezoelektrische Faser (A) uniaxial orientiert ist und einen Kristall enthält.

6. Piezoelektrisches Element nach Anspruch 1, wobei die leitfähige Faser (B) eine Kohlefaser ist.

7. Piezoelektrisches Element nach Anspruch 3, wobei die isolierende Faser (C) eine Faser auf Polyethylenterephthalatbasis als Hauptkomponente umfasst.

8. Piezoelektrisches Element nach Anspruch 2, das ein gewebtes oder gestricktes Textilmaterial ist, das eine Vielzahl paralleler piezoelektrischer Einheiten umfasst.

9. Piezoelektrisches Element nach Anspruch 8, das ein gewebtes Textilmaterial ist, welches eine Vielzahl von parallelen piezoelektrischen Einheiten umfasst und eine Satinbindungsstruktur hat.

10. Piezoelektrisches Element nach Anspruch 9, wobei die piezoelektrischen Einheiten in der Schussrichtung angeordnet sind.

11. Piezoelektrisches Element nach Anspruch 9, wobei die Schrittzahl einer piezoelektrischen Faser (A) in der piezoelektrischen Einheit 3 bis 7 ist.

12. Piezoelektrisches Element nach einem der Ansprüche 1 bis 11, das ein Sensor zum Detektieren der Größe der Beanspruchung ist, die auf das piezoelektrische Element und/oder die Ausübungsposition ausgeübt wurde.

13. Piezoelektrisches Element nach Anspruch 12, wobei die Beanspruchung, die auf das piezoelektrische Element ausgeübt wird und zu detektieren ist, Reibkraft auf der Oberfläche des piezoelektrischen Elements ist.

14. Piezoelektrisches Element nach einem der Ansprüche 1 bis 11, das ein Aktor ist, der seine Gestalt gemäß einem elektrischen Signal verändert, die an das piezoelektrische Element angelegt wird.

## Revendications

1. Élément piézoélectrique comprenant une unité piézoélectrique, **caractérisé en ce que** l'unité piézoélectrique comprend deux fibres conductrices (B) et une fibre piézoélectrique (A), agencées dans l'ordre une fibre conductrice (B), une fibre piézoélectrique (A) et une fibre conductrice (B), dont toutes sont agencées sensiblement sur le même plan tout en ayant des points de contact entre elles,
la fibre piézoélectrique (A) comprenant de l'acide polylactique comme constituant principal.

2. Élément piézoélectrique selon la revendication 1, dans lequel l'unité piézoélectrique comprend une fibre conductrice (B), une fibre piézoélectrique (A) et une fibre conductrice (B) dont toutes sont agencées sensiblement parallèles les unes aux autres.

3. Élément piézoélectrique selon la revendication 1, dans lequel l'unité piézoélectrique comprend une fibre isolante (C) qui est agencée de sorte que les fibres conductrices (B) dans l'unité piézoélectrique ne soient pas en contact avec les fibres conductrices (B) et une fibre piézoélectrique (A) dans une autre unité piézoélectrique.

4. Élément piézoélectrique selon la revendication 1, dans lequel la fibre piézoélectrique (A) comprend de l'acide poly-L-lactique ou de l'acide poly-D-lactique en tant que constituant principal et les puretés optiques de ces constituants sont supérieures ou égales à 99 %.

5. Élément piézoélectrique selon la revendication 1, dans lequel la fibre piézoélectrique (A) est orientée de façon uniaxe et contient un cristal.

6. Élément piézoélectrique selon la revendication 1, dans lequel la fibre conductrice (B) est une fibre de carbone.

7. Élément piézoélectrique selon la revendication 3, dans lequel la fibre isolante (C) comprend une fibre à base de polyéthylène téréphtalate comme constituant principal.

8. Élément piézoélectrique selon la revendication 2 qui est un tissu tissé ou tricoté comprenant une pluralité d'unités piézoélectriques parallèles.

9. Élément piézoélectrique selon la revendication 8 qui est un tissu tissé comprenant une pluralité d'unités piézoélectriques parallèles et ayant une structure d'armure satin.

10. Élément piézoélectrique selon la revendication 9, dans lequel les unités piézoélectriques sont agencées dans la direction de trame.

11. Élément piézoélectrique selon la revendication 9, dans lequel le nombre d'étapes d'une fibre piézoélectrique (A) dans l'unité piézoélectrique est de 3 à 7.

12. Élément piézoélectrique selon l'une quelconque des revendications 1 à 11 qui est un capteur permettant de détecter la taille d'une contrainte appliquée à l'élément piézoélectrique et/ou la position d'application.

13. Élément piézoélectrique selon la revendication 12, dans lequel une contrainte appliquée à l'élément piézoélectrique à détecter est une force de ponçage sur la surface de l'élément piézoélectrique.

14. Élément piézoélectrique selon l'une quelconque des revendications 1 à 11 qui est un actionneur qui change de forme en fonction d'un signal électrique appliqué à l'élément piézoélectrique.
